(19) Europäisches Patentamt / European Patent Office / Office européen des brevets

(11) **EP 4 431 645 A1**

(12) **EUROPEAN PATENT APPLICATION**
published in accordance with Art. 153(4) EPC

(43) Date of publication:
**18.09.2024 Bulletin 2024/38**

(21) Application number: **22889704.7**

(22) Date of filing: **01.10.2022**

(51) International Patent Classification (IPC):
*C30B 29/36* (2006.01)  *C30B 25/18* (2006.01)

(52) Cooperative Patent Classification (CPC):
**C30B 25/18; C30B 29/36**

(86) International application number:
**PCT/JP2022/036878**

(87) International publication number:
**WO 2023/079880 (11.05.2023 Gazette 2023/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.11.2021 JP 2021182078**

(71) Applicant: Shin-Etsu Handotai Co., Ltd.
**Tokyo 100-0004 (JP)**

(72) Inventors:
• **MATSUBARA Toshiki**
  **Nishishirakawa-gun, Fukushima 961-8061 (JP)**
• **SUZUKI Atsushi**
  **Nishishirakawa-gun, Fukushima 961-8061 (JP)**
• **OHTSUKI Tsuyoshi**
  **Nishishirakawa-gun, Fukushima 961-8061 (JP)**
• **ABE Tatsuo**
  **Nishishirakawa-gun, Fukushima 961-8061 (JP)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **METHOD FOR PRODUCING HETEROEPITAXIAL WAFER**

(57)    The present invention is a method for producing a heteroepitaxial wafer heteroepitaxially growing a 3C-SiC single crystal film on a single crystal silicon substrate, the method includes, with using a reduced-pressure CVD apparatus, a first step of removing a native oxide film on a surface of the single crystal silicon substrate by hydrogen baking and a second step of supplying a source gas containing carbon and silicon into the reduced-pressure CVD apparatus and forming the 3C-SiC single crystal film having wettability with a contact angle of 50° or less with liquid on a surface thereof. This provides the method for producing the heteroepitaxial wafer that can obtain a wafer capable of heteroepitaxially growing high-quality GaN and the like on the 3C-SiC single crystal film formed on the single crystal silicon substrate.

[FIG. 1]

**Description**

TECHNICAL FIELD

The present invention relates to a method for producing a heteroepitaxial wafer heteroepitaxially growing a 3C-SiC single crystal film on a single crystal silicon substrate.

BACKGROUND ART

3C-SiC is very effective for device substrates for power devices, high-frequency devices, and devices under radiation environments owing to characteristics such as excellent thermal conductivity, chemical stability under high-temperature environments, and a wider bandgap compared with silicon.

Consequently, heteroepitaxial growth on silicon substrates has been extensively studied (Non Patent Document 1).

Two-stage growth has been adopted as a general heteroepitaxial growth method. This method is carbonization of silicon and following SiC growth. For CVD, gases such as $SiH_4$ or chlorosilane are used as silicon sources, and gases such as $C_3H_8$ or $CH_4$ are used as carbon sources. These gases typically react at a temperature higher than 1200°C. However, high-temperature growth causes a problem in generating tensile stress due to a lattice-constants mismatch between Si and SiC.

In the circumstances, to avoid this problem even a little, low-temperature growth has developed using a reduced-pressure CVD apparatus (Non Patent Document 2).

This method is to grow by diluting trimethylsilane or monomethylsilane gas with hydrogen at low temperatures of 1000°C or lower using the reduced pressure CVD apparatus for carbonizing silicon and subsequent growing SiC. This method is supposed to enable high-quality and less stressed 3C-SiC epitaxial growth by making the CVD growth, in which the growth has been exposed to high temperatures for a long time, at a low temperature.

In addition, the method without silicon carbonization that requires a high temperature has been proposed (Non Patent Document 3).

In this method, a silicon substrate is heated to 900 to 1000°C under a high vacuum (lower than $7 \times 10^{-5}$ Pa ($5 \times 10^{-7}$ Torr)) and growth is performed using disilabutan as a raw material gas. This method does not include a carbonization step, and film-forming in a relatively low-temperature environment is possible.

Moreover, a substrate in which SiC is grown on silicon followed by GaN growth has been reported. GaN has an excellent Johnson index, an indicator for high-frequency characteristics and high-power devices. Consequently, due to these excellent characteristics, GaN has recently attracted attention as high-frequency device substrates with 5G in mind. However, GaN freestanding substrates having a large diameter have not been realized, and there is a problem considering mass productivity. Therefore, heteroepitaxial growth on inexpensive substrates such as Si as substrates has been considered feasible in many studies. Concerning the heteroepitaxial growth on silicon, SiC being grown between silicon and GaN has been reported (Non Patent Document 4).

In this report, a crack in a GaN layer can be prevented by forming a SiC layer as an intermediate layer between silicon and GaN. This is considered that the crack is generated not during epitaxial growth but during the cooling process after the epitaxial growth. In other words, a linear expansion coefficient of 3C-SiC is $4.6 \times 10^{-6}$ $K^{-1}$, while that of Si is $4.2 \times 10^{-6}$ $K^{-1}$, and that of GaN is $5.59 \times 10^{-6}$ $K^{-1}$. Thus, it is considered that 3C-SiC has an intermediate value between Si and GaN, thus mitigating thermal contraction during substrate cooling after epitaxial growth.

There have been various reports concerning this GaN growth on SiC; in general, it is considered that excellent GaN growth is enabled by performing surface modification (pretreatment) by flowing gases such as trimethylaluminum before GaN growth (Non Patent Document 5) .

In Non Patent Document 5 described above, a surface of SiC is described as "the poor wetting" because the surface is modified by performing the pretreatment using gases such as trimethylaluminum before GaN growth.

CITATION LIST

NON PATENT LITERATURE

Non Patent Document 1: J. Crystal. Growth, 154, 303 (1995)
Non Patent Document 2: J. Electrochem. Soc, 139, 3565 (1992)
Non Patent Document 3: J. Crystal. Growth, 179, 153 (1997)
Non Patent Document 4: Appl. Phys. Lett., 88, 091901(2006)

Non Patent Document 5: Jpn. J. Appl. Phys., 55, 05FB06 (2016)

SUMMARY OF INVENTION

TECHNICAL PROBLEM

In this way, a heteroepitaxial substrate with GaN grown after SiC growth on a silicon substrate is very attractive because it is possible for diameter enlargement, such as 300 mm in diameter. However, in addition that SiC epitaxial growth is performed at a high temperature, in particular, a pretreatment for GaN growth is necessary. Moreover, even if the pretreatment at the GaN growth is performed, it does not guarantee the GaN growth on the SiC, thus, considerable effort has been required to find a condition for a growth process.

The present invention has been made to solve the above-described problem. An object of the present invention is to provide a method for producing a heteroepitaxial wafer in which a wafer capable of heteroepitaxial growing excellent GaN and the like on a 3C-SiC single crystal film formed on a single crystal silicon substrate can be obtained.

SOLUTION TO PROBLEM

To achieve the described object, the present invention provides a method for producing a heteroepitaxial wafer heteroepitaxially growing a 3C-SiC single crystal film on a single crystal silicon substrate, the method comprising: with using a reduced-pressure CVD apparatus,

a first step of removing a native oxide film on a surface of the single crystal silicon substrate by hydrogen baking; and
a second step of supplying a source gas containing carbon and silicon into the reduced-pressure CVD apparatus and forming the 3C-SiC single crystal film having wettability with a contact angle of 50° or less with liquid on a surface thereof.

In this way, by removing the native oxide film on the surface of the single crystal silicon substrate in the first step, the forming of the 3C-SiC single crystal film is enabled in the second step (nucleation stage, film-forming stage).

In addition, by making the wettability (contact angle) on the surface of the 3C-SiC single crystal film a new indicator as a film-forming condition in the second step, the heteroepitaxial wafer can be obtained in which the following epitaxial growth can be performed more easily and reliably on the 3C-SiC single crystal film. In particular, the heteroepitaxial wafer capable of heteroepitaxially growing excellent GaN can be obtained more reliably without performing pretreatment performed in a conventional method. Consequently, a reduction of labor and cost can be attempted.

In this case, the contact angle as an indicator of the wettability of the 3C-SiC single crystal film can be a contact angle when $H_2O$ is used as the liquid.

As just described, when the contact angle, in which $H_2O$ is used, is defined as the indicator, it is simple and convenient when the contact angle is measured for confirmation after the film-forming, for example.

In addition, a nucleation stage to perform a SiC nucleation on the single crystal silicon substrate and a film-forming stage to form the 3C-SiC single crystal film by growing a SiC single crystal are included as the second step, and the nucleation stage can be performed on condition that pressure is 13332 Pa or lower and a temperature is maintained at a constant temperature in a range of 300°C or higher and 950°C or lower.

In this way, the SiC nucleation can be performed more efficiently. In addition, the heteroepitaxial wafer having the contact angle of 50° or less described above can be obtained more reliably.

Moreover, the film-forming stage can be performed on condition that the pressure is 6666 Pa or lower, and the temperature is 800°C or higher and 1200°C or lower.

Under these growth conditions, epitaxial growth can be controlled by transport of a supply gas, and epitaxial growth by Layer by Layer is possible; in addition, surface-free energy can surely be controlled by a state suitable to GaN growth.

Moreover, it is possible to prevent a generation of slip dislocation.

Furthermore, a vacancy can be formed in a silicon layer (single crystal silicon substrate) directly under the 3C-SiC single crystal film while growing the 3C-SiC single crystal film. The presence of the vacancy mitigates not only a lattice mismatch between 3C-SiC and silicon but also the stress-relaxes of an entire epitaxial layer, thus enabling more reliable formation of the 3C-SiC single crystal film without crystal defects even for a thick 3C-SiC single crystal film.

Furthermore, the first step can be performed on condition that the temperature is 1000°C or higher and 1200°C or lower.

In this way, the native oxide film on the surface of the single crystal silicon substrate can be removed more efficiently, and the generation of the slip dislocation can be prevented.

The source gas can be monomethylsilane or trimethylsilane.

Such a raw material gas can supply both Si and C by a single gas; thus, the step of nucleation, which is called carbonization before the 3C-SiC single crystal film growth, is also unnecessary, in which a carbon atom is attached to the surface of the single crystal silicon substrate by the gas containing carbon source precursor. Then, forming the 3C-SiC single crystal film is enabled on a very simple condition.

Moreover, compared with a method in which the carbon atom is first attached on the surface of the single crystal silicon substrate by a gas containing carbon source precursor for nucleation, and then the 3C-SiC single crystal film is formed using the gas containing carbon source precursor and a gas containing silicon source precursor; reactive active species in the gas phase are more controllable, and the heteroepitaxial growth is more reliable, thereby forming the thick 3C-SiC single crystal film much easier without stopping the growth of a 3C-SiC single crystal.

In addition, a GaN layer can be formed on the surface of the formed 3C-SiC single crystal film by further growing GaN thereon.

The present invention is particularly effective when forming the GaN layer with the 3C-SiC single crystal film as an intermediate layer on the single crystal silicon substrate, and the GaN layer having excellent film quality can be obtained more conveniently and surely than conventional means.

ADVANTAGEOUS EFFECTS OF INVENTION

According to the inventive method for producing the heteroepitaxial wafer, the heteroepitaxial wafer can be provided, which has the 3C-SiC single crystal film on the single crystal silicon substrate and is suitable for heteroepitaxial growing GaN and the like with excellent film quality on the 3C-SiC single crystal film.

Moreover, the heteroepitaxial wafer can be provided with the GaN layer further formed on the 3C-SiC single crystal film.

BRIEF DESCRIPTION OF DRAWINGS

FIG. 1 is a graph illustrating an example of a 3C-SiC growth sequence in a method for producing a heteroepitaxial wafer according to the present invention. This is also the graph illustrating the 3C-SiC growth sequence of Example 1.

FIG. 2 is a graph illustrating a result of In plane XRD analysis of 3C-SiC on Si(111) grown in a 3C-SiC growth sequence of Example 1.

FIG. 3 is a cross-sectional TEM image of GaN on 3C-SiC on Si(111) grown on a 3C-SiC single crystal film of Example 1.

FIG. 4 is a graph illustrating an XRD rocking curve of GaN grown on a 3C-SiC single crystal film of Example 1.

FIG. 5 is a graph illustrating a 3C-SiC growth sequence of Comparative Example.

FIG. 6 is a graph illustrating a result of In plane XRD analysis of 3C-SiC on Si(111) grown in a 3C-SiC growth sequence of Comparative Example.

FIG. 7 is a cross-sectional TEM image of GaN on 3C-SiC on Si(111) grown on a 3C-SiC single crystal film of Comparative Example.

FIG. 8 is a graph illustrating an XRD rocking curve of GaN grown on a 3C-SiC single crystal film of Comparative Example.

FIG. 9 is an explanatory diagram of a contact angle.

FIG. 10 is a schematic diagram of vapor phase growth (BCF) model.

DESCRIPTION OF EMBODIMENTS

Hereinafter, embodiments of the present invention will be described with reference to the drawings. However, the present invention is not limited thereto.

A method for producing a heteroepitaxial wafer has been desired, which can form a 3C-SiC single crystal film on a single crystal silicon substrate and can further form GaN and the like having excellent film quality on the 3C-SiC single crystal film. The present inventors have earnestly studied and found that in order to produce the heteroepitaxial wafer that meets the above requirements, a wettability (contact angle) of a surface of the 3C-SiC single crystal film is required to be used as an indicator in the forming of the 3C-SiC single crystal film, and the wettability is required to have the contact angle of 50° or less. This finding has led to the completion of the present invention.

In fact, even when the SiC surface is treated with hydrofluoric acid, fluoronitric acid, aqua regia, or by high-temperature annealing at 1150°C (annealing at 1150°C because an underlayer is a silicon substrate) with $H_2$, the wettability of the SiC surface does not change, and post-treatment after the film-forming cannot control the surface wettability like silicon.

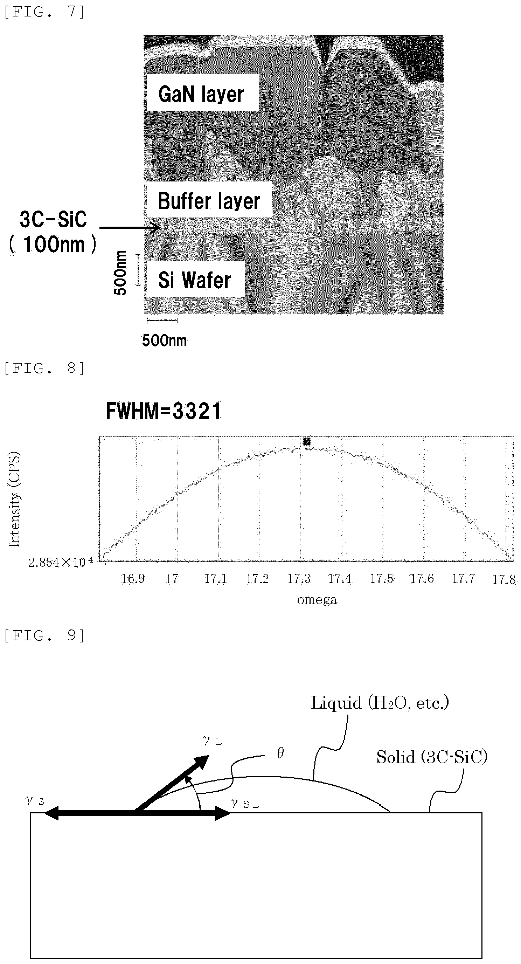

At this point, a description is given regarding the contact angle. The contact angle indicates an angle between a tangent line drawn to a liquid and a solid surface, in which the angle includes the liquid side, at a contact point of three phases of solid, liquid, and gas when the liquid is on the solid surface in air, as shown in FIG. 9. In addition, this contact angle is determined by a surface tension of the liquid (in this case, for example, $H_2O$) and a surface tension of the solid surface (the 3C-SiC surface in the present invention), and interfacial tension between the solid and liquid, as shown by Young's Equation in following (Formula 1).

At this point, the surface tensions of solid and liquid are an intermolecular force (van der Waals force) in bulk generated by the emergence of the surface which is an interface (surface free energy). Accordingly, it can be understood that a growth condition of an epitaxial layer (bulk) affects the contact angle.

$$\gamma_S = \gamma_L \cos\theta + \gamma_{SL} \quad \ldots (\text{Formula 1})$$

wherein,

Contact angle: $\theta$
Surface tension of solid: $\gamma_s$
Surface tension of liquid: $\gamma_L$
Interfacial tension between solid and liquid: $\gamma_{SL}$

The 3C-SiC single crystal film grown in this way is in the state in which the contact angle, i.e., surface free energy, is controlled; thus, it is the substrate suitable for heteroepitaxial growth thereon (particularly for GaN growth).

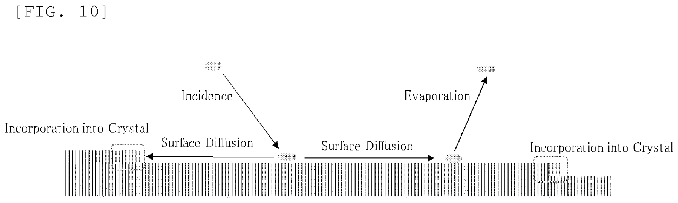

In practice, a generally accepted epitaxial growth model, a vapor phase growth (BCF) model (Phil. Trans. Royal Soc. London, 243, 299-358 (1951)), is shown in FIG. 10. In this model, the epitaxial growth is shown as (formula 2) described below
[Math. 1]

$$\frac{\partial c}{\partial t} = D_s \nabla^2 c + f - \frac{1}{\tau} c \quad \cdots (\text{Formula 2})$$

wherein,

c: Surface concentration of an active species
$D_s$: Diffusion coefficient of the active species
f: Incidence rate (f = P / SQRT ($2nmk_BT$))
$\tau$: Time that the active species remains on the surface (lifetime)
P: Pressure
m: Mass
$k_B$: Boltzmann constant
T: Temperature

Here, the surface concentration of the active species can be written as follows so as to be affected by the surface tension.
[Math. 2]

$$c = c_0 - \frac{\Omega_2 c_0}{k_B T} F \quad \cdots (\text{Formula 3})$$

wherein,

$c_0$: Concentration when F = 0
$\Omega_2$: Area occupied by 1 atom
$k_B$: Boltzmann constant
T: Temperature
F: Surface tension

As in (Formula 3), it is obvious that the surface tension affects the epitaxial growth.

Hereinafter, the method for manufacturing the heteroepitaxial wafer will be described with reference to the specific examples. However, the present invention is not limited thereto.

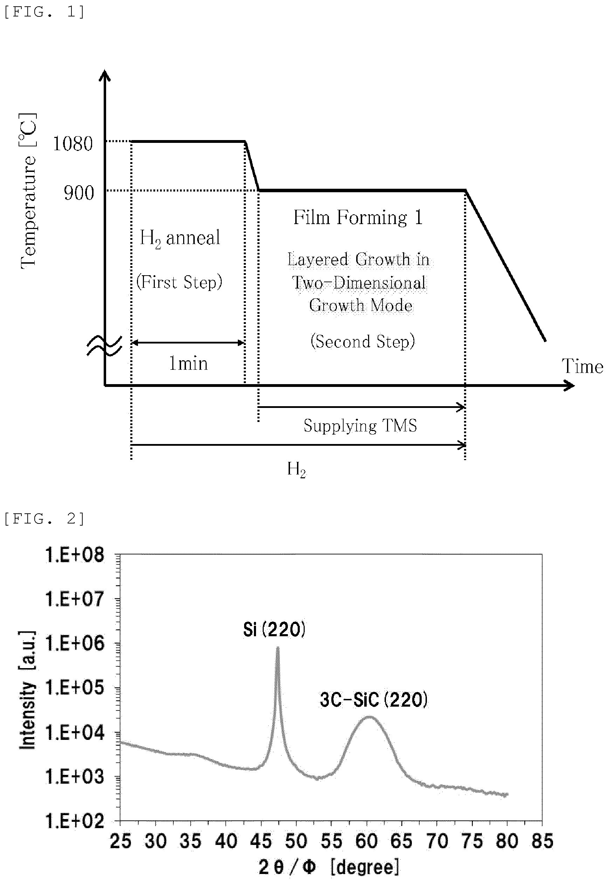

FIG. 1 shows an example of a 3C-SiC growth sequence. A first step for hydrogen baking (hereinafter, also referred to as $H_2$ anneal), and a second step for forming step of the 3C-SiC single crystal film (a nucleation stage to perform nucleation of SiC, film-forming stage to form the 3C-SiC single crystal film by growing a SiC single crystal) are performed in sequence. Each step is described below.

<First Step>

To begin with, a single crystal silicon substrate is placed in a reduced-pressure CVD apparatus (hereinafter, also referred to as an RP-CVD apparatus), and a hydrogen gas is introduced, and then a native oxide film on the surface is removed by $H_2$ anneal. When the oxide film remains, the nucleation of SiC on the single-crystal silicon substrate becomes impossible. $H_2$ anneal, in this case, is preferably on condition of, for example, a temperature of 1000°C or higher and 1200°C or lower. Making the temperature 1000°C or higher can prevent long processing time to prevent residual native oxide film, thus being efficient. Meanwhile, making the temperature 1200°C or lower can effectively prevent a generation of a slip dislocation due to high temperature. However, the pressure or time of $H_2$ anneal at the time has no particular restriction as long as the native oxide film can be removed.

In the example shown in FIG. 1, $H_2$ anneal is performed at 1080°C for 1 minute. Meanwhile, the introduction of the hydrogen gas can be continued after the first step as well as in the second step (carrier gas) .

<Second Step (Nucleation Stage)>

Then, the single crystal silicon substrate is set to a predetermined pressure and temperature, and a source gas containing carbon and silicon is introduced as a raw material gas for SiC into the RP-CVD apparatus, and then the nucleation of SiC is performed. For example, monomethylsilane or trimethylsilane (TMS) can be introduced as the source gas. It is simpler and easier to control than using a plurality of types of gases, and more reliable formation of the 3C-SiC single crystal film is possible. Further, since C has smaller atoms and vaporizes more easily than Si, trimethylsilane is easier for a condition setting regarding raw material efficiency.

Such introduction of the source gas is performed in the nucleation stage and the following film-forming stage of this second step.

In addition, this nucleation of SiC can be performed efficiently on a surface of the single crystal silicon substrate on condition of, for example, pressure of 13332Pa (100Torr) or less, and a constant temperature being maintained in a range of 300°C or higher and 950°C or lower.

In the SiC nucleation stage, by making the condition in which the temperature is 950°C or less, it can be more surely prevented that the reaction between the single crystal silicon substrate and the raw material gas progresses due to too high temperature, and results in being impossible to perform the SiC nucleation on the surface of the single crystal silicon substrate. Moreover, the wettability having a contact angle of 50° or less with liquid on the surface of the 3C-SiC single crystal film after forming can be more surely obtained. In particular, by making a temperature 900°C or lower, the wettability having a contact angle of 40° or less can be obtained with ease.

In addition, the above liquid is not limited, however, $H_2O$ can be used in general. $H_2O$ can be easily provided and measured, for example, when confirming the contact angle after the film-forming.

Moreover, by making a temperature of 300°C or higher, this can more reliably prevent the SiC nucleation from being incapable of performing efficiently due to too low temperature.

Meanwhile, taking into consideration the film-forming stage together described next, by making a temperature of 800°C or higher during the film-forming stage, the heteroepitaxial growth of SiC can proceed efficiently. Thus, for example, from at the point of the nucleation stage, the temperature of nucleation of SiC can be preferably set to 800°C or higher and 950°C or lower, more preferably 850°C or higher and 900°C or lower. As just described, by setting the temperature in the nucleation stage to 800°C or higher and 950°C or lower, the preferable temperature range to be set for the SiC nucleation stage and the one to be set for the film-forming stage, which is the subsequent 3C-SiC single crystal film-forming, can be overlapped. In particular, this nucleation stage and the film-forming stage can be performed under the same temperature conditions.

Furthermore, owing to setting the pressure to 13332 Pa (100 Torr) or lower, generation of the secondary or higher-order reactions can be prevented, such as the reaction of the reactive active species with the raw material gas in a vapor phase, thus efficient. Further preferably, the pressure can be made to 133 Pa (1 Torr) or lower, and thus more efficient. The lower limit of the pressure is not particularly limited but can be 13.3 Pa (0.1 Torr), for example. Note that the pressure as well as the temperature can be in the same condition in the nucleation stage and the film-forming stage.

In an example shown in FIG. 1, this nucleation stage and the subsequent film-forming stage have an identical condition with the same pressure and the same retention temperature (900°C).

<Second Step (Film-Forming Stage)>

In addition, the film-forming stage, in which the 3C-SiC single crystal film is grown and formed, can be performed, for example, on condition that the pressure is 13332 Pa (100 Torr) or even 6666 Pa (50 Torr) or lower, and the temperature is 800°C or higher and lower than 1200°C. Under the condition, the SiC single crystal can be efficiently grown, thereby forming the 3C-SiC single crystal film.

Moreover, by making the growth pressure 13332 Pa (moreover, 6666 Pa) or lower, polycrystallization of the formed 3C-SiC can be prevented more reliably. When the pressure is kept to 6666 Pa (50 Torr) or lower, the secondary or higher-order reactions in the vapor phase can be suppressed as described above, the polycrystallization of the 3C-SiC can be prevented, and the 3C-SiC single crystal film can be formed reliably and efficiently. In addition, the pressure can be preferably 1333 Pa (10 Torr) or lower, and even 133 Pa (1 Torr) or lower. Under these conditions, a vacancy is formed directly under the 3C-SiC single crystal film, thereby obtaining an effect of relaxing stress of an entire heteroepitaxial layer. The lower pressure limit is not particularly limited but can be 13.3 Pa (0.1 Torr), for example.

In addition, as for the temperature, the growth of the SiC single crystal can efficiently proceed as described above when the temperature is 800°C or higher, and generation of the slip dislocation can be effectively prevented by making the temperature 1200°C or lower.

In the example shown in FIG. 1, the nucleation stage and the film-forming stage are on the same conditions as described above, and the nucleation of SiC and the formation of 3C-SiC single crystal film are performed consecutively.

At this time, a film thickness depends on the pressure and the temperature; film-forming time can be determined appropriately based on the set pressure and temperature conditions to achieve the desired film thickness.

In this case, the film thickness of the 3C-SiC single crystal film can be formed from a thin film of about 2 nm to a thick film of several $\mu$m, for example, and the surface contact angle is 50° or less, then the surface free energy becomes suitable for GaN growth, and then a layered growth in two-dimensional growth mode is enabled.

In addition, the layered growth in two-dimensional growth mode shown in FIG. 1 is a layer by layer epitaxial growth.

The heteroepitaxial wafer grown in this way, on which 3C-SiC single crystal film having the wettability with the contact angle of 50° or less (more than 0°) with liquid ($H_2O$) on the surface is formed, is suitable to form further heteroepitaxial layer such as GaN thereon. In other words, when GaN, in particular, is grown on that 3C-SiC single crystal film, the heteroepitaxial wafer having a high-quality GaN layer can be obtained.

The GaN growth at this time is film-formed by the MOCVD using organometallic materials such as trimethylgallium and trimethylammonium, and GaN is grown for about 3 um.

Further, instead of GaN, the heteroepitaxial growth of Si, for example, is also possible.

The smaller the contact angle described above, the more suitable the surface free energy for the GaN growth. Thus, the heteroepitaxial layer having excellent film quality can be more reliably formed on the 3C-SiC single crystal film.

Note that a measurement of the contact angle can be measured using a measurement apparatus on the market, for example. As an example, PCA-11 manufactured by Kyowa Interface Science Co., Ltd. can be mentioned. The measurement can be performed by dropping 2.0 $\mu$L of pure water droplets at five locations on the surface of the 3C-SiC single crystal film, determining the contact angle from image analysis, and averaging thereof. However, the measurement method is not limited to this method.

As described above, the description is given following the growth sequence shown in FIG. 1 here; however, in the inventive method for manufacturing the heteroepitaxial wafer, the condition at film-forming is not limited to the above-described pressure range or temperature range. The film-forming condition in which the contact angle is 50° or less on the surface of the 3C-SiC single crystal film after film-forming is sufficient, and due to the variety of condition patterns for the 3C-SiC single crystal film during the heteroepitaxial growth can be conceived, the condition can be determined appropriately.

For example, a correlation between the pressure and temperature conditions when forming the 3C-SiC single crystal film and the contact angle on the surface of the 3C-SiC single crystal film after forming is obtained in advance by conducting tests under the varied pressure and temperature conditions. When actually manufacturing a product, the manufacture is enabled based on this correlation, setting the pressure and temperature conditions at the time of 3C-SiC single crystal film-forming, under which the contact angle is 50° or less after film-forming.

A finding itself by inventors has a great meaning, in which the use of the contact angle as the indicator for the condition of heteroepitaxial growing the 3C-SiC single crystal film is exceedingly effective for forming the heteroepitaxial layer such as GaN further on the film. The 3C-SiC single crystal film may be manufactured by adjusting the condition for forming so as to satisfy the condition of the contact angle described above. In addition, the high-quality heteroepitaxial film such as GaN can be reliably obtained owing to no need for pretreatment, unlike conventional means, before forming the heteroepitaxial layer such as GaN after forming the 3C-SiC single crystal film, thus easier.

EXAMPLE

Hereinafter, the present invention will be more specifically described with reference to Examples and Comparative Example of the present invention. However, the present invention is not limited thereto.

(Example 1)

A high-resistivity single crystal silicon substrate having a diameter of 300 mm, plane orientation (111), and boron-doped was provided, and the wafer was placed on a susceptor in a reactor of an RP-CVD apparatus, and then $H_2$ anneal was performed at 1080°C for 1 minute as in a growth sequence shown in FIG. 1 (First Step). Then, a trimethylsilane gas was film, thusat a growth temperature of 900°C and a growth pressure of 6666 Pa (50 Torr), then SiC was nucleated, and a 3C-SiC single crystal film was grown (a nucleation stage and a film-forming stage of the second step). As a result of 5 minutes of growth, the film had a thickness of 13 nm.

Subsequently, when an XRD (X-ray diffraction) spectrum was confirmed in In Plane arrangement, as shown in a graph of an XRD analysis result in FIG. 2, it was possible to confirm a peak of 3C-SiC (220) parallel to Si (220), thus the growth of a single crystalline 3C-SiC film was confirmed.

A contact angle on a surface of the formed 3C-SiC single crystal film was 19.7°. PCA-11 manufactured by Kyowa Interface Science Co., Ltd. was used to measure this contact angle. The measurement was performed by dropping 2.0 μL of pure water droplets at five locations on the surface of the 3C-SiC single crystal film, determining the contact angle from image analysis, and averaging thereof.

In addition, GaN growth on the 3C-SiC single crystal film was attempted.

More specifically, this growth substrate (single crystal silicon substrate + 3C-SiC single crystal film) was mounted in an MOCVD reaction furnace, and a group III nitride semiconductor thin film such as AlN, AlGaN, and GaN was epitaxially grown on the growth substrate. The growth substrate was mounted on a wafer pocket called a satellite. During epitaxial growth, TMAl was used as an Al source, TMGa as a Ga source, and $NH_3$ as an N source.

Moreover, both $N_2$ and $H_2$ were used as carrier gases. A process temperature was about 900 to 1200°C. When the growth substrate was mounted on the satellite and epitaxially grown, an epitaxial layer was formed with AlN and AlGaN in order toward the growth direction from the substrate side, and then GaN was epitaxially grown.

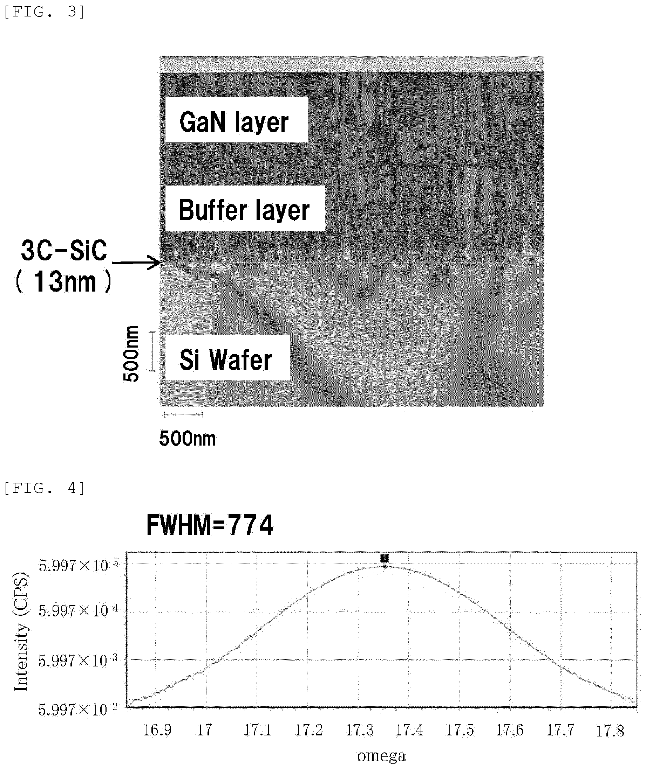

A cross-sectional TEM image of the grown GaN was shown in FIG. 3, and an XRD rocking curve of that was shown in FIG. 4. As shown in FIG. 3, three-dimensional island-shape growth as in Comparative Example described later was not observed. Moreover, the full width half maximum (FWHM: Full Width Half Maximum) of a peak value (when omega = 17.35°) of the rocking curve was 774 seconds in FIG. 4, significantly narrower than the full width half maximum in Comparative Example. In this way, it was possible to grow the GaN film having excellent crystallinity.

(Comparative Example)

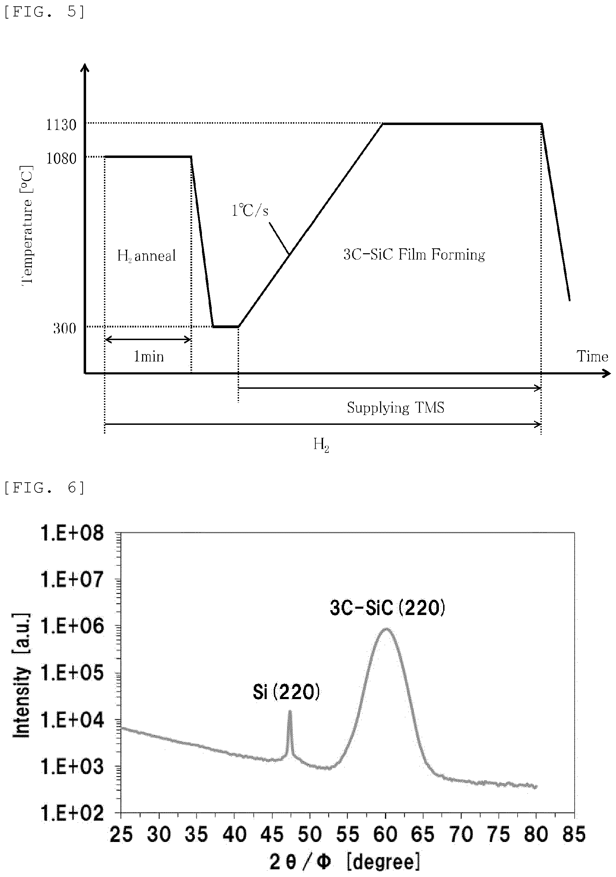

A high-resistivity single crystal silicon substrate having a diameter of 300 mm, plane orientation (111), and boron-doped was provided, and the wafer was placed on a susceptor in a reactor of an RP-CVD apparatus, and then $H_2$ anneal was performed at 1080°C for 1 minute as in a growth sequence shown in FIG. 5. Subsequently, the temperature in a furnace was lowered to 300°C; then the temperature was raised to 1130°C at a rate of temperature rise of 1°C/sec while introducing trimethylsilane gas for nucleation of SiC and subsequent formation of 3C-SiC single crystal film. In this event, a growth pressure was uniformly 133 Pa (1 Torr). After reaching 1130°C and holding for 10 minutes, the 3C-SiC single crystal film was grown, resulting in a film thickness of about 100 nm.

When an XRD spectrum was confirmed in In plane arrangement after the film-forming, as shown in a graph of an XRD analysis result in FIG. 6, it was possible to confirm a peak of 3C-SiC (220) parallel to Si (220), thus the growth of a single crystalline 3C-SiC film was confirmed.

When a contact angle of a surface of the formed 3C-SiC film was measured as in Example 1, the contact angle was 66.8°.

Furthermore, under the same condition as in Example 1, GaN growth was attempted on the 3C-SiC single crystal film.

FIG. 7 showed a cross-sectional TEM image of grown GaN and FIG. 8 showed an XRD rocking curve. As shown in FIG. 7, GaN was grown in a three-dimensional island shape. Moreover, the full width half maximum (FWHM) of a peak value (when omega = 17.32°) of the rocking curve in FIG. 8 was 3321 seconds, being wide. Thus, GaN film having excellent crystallinity was unable to be obtained.

(Example 2)

A single crystal silicon substrate, as in Example 1, was provided, and the wafer was placed on a susceptor in a reactor of an RP-CVD apparatus, and then $H_2$ anneal was performed at 1080°C for 1 minute (First Step). Subsequently, as a nucleation stage in the second step, a trimethylsilane gas was introduced at a growth temperature of 900°C for 5 minutes. Then, as a film-forming stage in the second step, the growth temperature was raised to 1190°C, and the trimethylsilane gas was introduced to grow a 3C-SiC single crystal film. In this event, a growth pressure was uniformly 133 Pa (1 Torr). As a result of 1 minute of growth, the film had a thickness of about 50 nm.

After the film-forming, when an XRD spectrum was confirmed in In plane arrangement, a peak of 3C-SiC (220) parallel to Si (220) was able to be confirmed, thus, the growth of a single crystalline 3C-SiC film was confirmed.

When a contact angle on a surface of the formed 3C-SiC film was measured as in Example 1, the contact angle was 50°.

Furthermore, when GaN growth was attempted on the 3C-SiC single crystal film on the same condition as in Example 1, a GaN film having excellent crystallinity was able to be obtained. Although not as high as that of Example 1, the crystallinity was superior to that of Comparative Example.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a heteroepitaxial wafer heteroepitaxially growing a 3C-SiC single crystal film on a single crystal silicon substrate, the method comprising: with using a reduced-pressure CVD apparatus,

   a first step of removing a native oxide film on a surface of the single crystal silicon substrate by hydrogen baking; and
   a second step of supplying a source gas containing carbon and silicon into the reduced-pressure CVD apparatus and forming the 3C-SiC single crystal film having wettability with a contact angle of 50° or less with liquid on a surface thereof.

2. The method for producing a heteroepitaxial wafer according to claim 1, wherein
   the contact angle as an indicator of the wettability of the 3C-SiC single crystal film is a contact angle when $H_2O$ is used as the liquid.

3. The method for producing a heteroepitaxial wafer according to claim 1 or 2, wherein

   a nucleation stage to perform a SiC nucleation on the single crystal silicon substrate and a film-forming stage to form the 3C-SiC single crystal film by growing a SiC single crystal are included as the second step, and
   the nucleation stage is performed on condition that pressure is 13332 Pa or lower and a temperature is maintained at a constant temperature in a range of 300°C or higher and 950°C or lower.

4. The method for producing a heteroepitaxial wafer according to claim 3, wherein
   the film-forming stage is performed on condition that the pressure is 6666 Pa or lower, and the temperature is 800°C or higher and 1200°C or lower.

5. The method for producing a heteroepitaxial wafer according to any one of claims 1 to 4, wherein
   the first step is performed on condition that the temperature is 1000°C or higher and 1200°C or lower.

6. The method for producing a heteroepitaxial wafer according to any one of claims 1 to 5, wherein
   the source gas is monomethylsilane or trimethylsilane.

7. The method for producing a heteroepitaxial wafer according to any one of claims 1 to 6, wherein
   a GaN layer is formed on the surface of the formed 3C-SiC single crystal film by further growing GaN thereon.

[FIG. 1]

[FIG. 2]

[FIG. 3]

[FIG. 4]

## FWHM=774

[FIG. 5]

[FIG. 6]

[FIG. 7]

3C-SiC
( 100nm )

GaN layer

Buffer layer

500nm

Si Wafer

500nm

[FIG. 8]

**FWHM=3321**

[FIG. 9]

[FIG. 10]

Incidence

Evaporation

Incorporation into Crystal

Surface Diffusion

Surface Diffusion

Incorporation into Crystal

| | INTERNATIONAL SEARCH REPORT | International application No. |
|---|---|---|
| | | **PCT/JP2022/036878** |

**A.     CLASSIFICATION OF SUBJECT MATTER**

*C30B 29/36*(2006.01)i; *C30B 25/18*(2006.01)i
FI:     C30B29/36 A; C30B25/18

According to International Patent Classification (IPC) or to both national classification and IPC

**B.     FIELDS SEARCHED**

Minimum documentation searched (classification system followed by classification symbols)

C30B29/36; C30B25/18

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.     DOCUMENTS CONSIDERED TO BE RELEVANT**

| Category* | Citation of document, with indication, where appropriate, of the relevant passages | Relevant to claim No. |
|---|---|---|
| X | JP 2003-212694 A (TOSHIBA CERAMICS CO LTD) 30 July 2003 (2003-07-30) paragraphs [0026]-[0028] | 1–6 |
| Y | | 7 |
| Y | JP 2002-234799 A (UNIV TOHOKU) 23 August 2002 (2002-08-23) paragraphs [0024], [0027]-[0032] | 1–7 |
| A | JP 2016-092399 A (SEIKO EPSON CORP) 23 May 2016 (2016-05-23) paragraph [0083] | 1–7 |
| Y | JP 2006-036613 A (NAGAOKA UNIV OF TECHNOLOGY) 09 February 2006 (2006-02-09) paragraphs [0018]-[0021] | 1–7 |
| Y | JP 2019-117908 A (AIR WATER INC) 18 July 2019 (2019-07-18) paragraphs [0008]-[0010], [0062]-[0064], fig. 9 | 7 |
| A | | 1–6 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 November 2022** | **06 December 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/036878**

| Patent document cited in search report | | | Publication date (day/month/year) | Patent family member(s) | Publication date (day/month/year) |
|---|---|---|---|---|---|
| JP | 2003-212694 | A | 30 July 2003 | (Family: none) | |
| JP | 2002-234799 | A | 23 August 2002 | US 2002/0102862 A1 paragraphs [0031], [0043]-[0051] CA 2356229 A | |
| JP | 2016-092399 | A | 23 May 2016 | US 2016/0126321 A1 paragraph [0092] CN 105575770 A | |
| JP | 2006-036613 | A | 09 February 2006 | (Family: none) | |
| JP | 2019-117908 | A | 18 July 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *J. Crystal. Growth,* 1995, vol. 154, 303
- *J. Electrochem. Soc,* 1992, vol. 139, 3565
- *J. Crystal. Growth,* 1997, vol. 179, 153
- *Appl. Phys. Lett.,* 2006, vol. 88, 091901
- *Jpn. J. Appl. Phys.,* 2016, vol. 55, 05FB06
- *Phil. Trans. Royal Soc. London,* 1951, vol. 243, 299-358